# EUROPÄISCHE PATENTSCHRIFT

(11) **EP 2 022 591 B1**
(45) Veröffentlichungstag und Bekanntmachung des Hinweises auf die Patenterteilung: **14.07.2010**
(21) Anmeldenummer: 07015252.5
(22) Anmeldetag: 03.08.2007
(51) Int. Cl.: B23K 1/20, H05K 3/34

(54) **Verfahren zur Erzeugung einer lötfähigen metallischen Oberfläche und Lötverfahren**
Method for creating a solderable metal surface and solder method
Procédé destiné à la production d'une surface métallique pouvant être soudée et procédé de soudage

(43) Veröffentlichungstag der Anmeldung: 11.02.2009
(73) Patentinhaber: SIEMENS AKTIENGESELLSCHAFT, 80333 München (DE); Messer Group GmbH, 65843 Sulzbach (DE)
(72) Erfinder: Hatz, Gottfried, 8461 Ehrenhausen (AT); Schaller, Karl-Heinz, 92289 Ursensollen (DE); Tauchmann, Jens, 47269 Duisburg (DE)

(56) Entgegenhaltungen:
- EP-A- 0 427 020
- WO-A-00/48779
- WO-A-93/19575
- DE-A1- 3 433 681
- US-A1- 2003 019 917

## Beschreibung

Die Verbindung zweier oder mehrerer Teile durch Verlöten ist ein beispielsweise in der Mikro- und Leistungselektronik weit verbreitetes Verfahren. Die Oberflächen der miteinander zu verbindenden Teile, beispielsweise von mit Kupfer beschichteten Grundplatten aus Polymermaterial oder einem keramischen Material, sog. DCB-Substrate (direct copper bonded substrates) und damit elektrisch leitend zu verbindende Bauteile wie Si-Chips sind in der Regel mit einer Oxidschicht überzogen. Diese Schicht und gegebenenfalls Verunreinigungen wie Fette und Öle verhindern eine Benetzung der Oberflächen mit Lotmaterial, so dass ohne Einsatz von Flussmitteln und Aktivatoren eine zuverlässige Lötverbindung nicht herstellbar ist. Vielfach ist trotz des Einsatzes der genannten Stoffe eine Vorreinigung beispielsweise mit Wasserstoff, organischen Säuren oder durch Beaufschlagung mit einem Plasma erforderlich. Selbst wenn durch eine solche Vorreinigung neben Verunreinigungen auch eine Oxidschicht vollständig entfernt wird, ist trotzdem der Einsatz von Flussmitteln und Aktivatoren erforderlich, weil sich die blanken Oberflächen sehr schnell wieder mit einer Oxidschicht überziehen. Das Flussmittel reduziert bei der Erwärmung auf den Oberflächen der Fügepartner und des Lotmaterials vorhandene Oxidschichten und verhindert die erneute Oxidbildung vor und während des Lötvorgangs durch Bildung einer flüssigen Schutzschicht. Aktivatoren sollen die Oxidschichten der Fügepartner unterwandern und aufbrechen. In der Elektrotechnik werden in erster Linie synthetische Harze oder auch natürliche Harze wie Kolophonium als Flussmittel und organische Zusätze wie Salicylsäure und Harnstoff als Aktivatoren verwendet. Die Harze nehmen beim Lötvorgang Metalle des Lotmaterials und der Fügepartner sowie Aktivatorsubstanz auf, was zu Kriechströmen, einer verringerten Spannungsfestigkeit der Lötstellen und zu Korrosionsproblemen führen kann. In aller Regel ist daher nach dem Löten ein Reinigungsschritt erforderlich, mit dem derartige Rückstände entfernt werden.

Es ist grundsätzlich bekannt, lötfähige metallische Oberflächen dadurch zu erzeugen, dass diese mit einem Plasma beziehungsweise einem Niederdruckplasma behandelt werden, zu dessen Erzeugung ein Prozessgas verwendet wird, das sich aus einem fluorierten Kohlenwasserstoff und einem Restgas zusammensetzt, siehe z. B. EP-A2-0 427 020. Die EP 0 427 020 A2 offenbart außerdem die Kombination von Fluorkohlenstoffen (auch Tetrafluorkohlenwasserstoff) mit anderen Gas wie Stickstoff und Sauerstoff (siehe Anspruch 2) sowie einen Druckbereich für das Plasma von 10 bis 200 Pa.

Davon ausgehend ist es die Aufgabe der Erfindung, Verfahren vorzuschlagen, mit denen sich ohne oder zumindest mit reduziertem Einsatz von Flussmitteln und Aktivatoren Lötverbindungen herstellen lassen.

Diese Aufgabe wird durch ein Lötverfahren nach Anspruch 1 gelöst. Für ein Lötverfahren zur Herstellung einer elektrisch leitenden Verbindung zweier eine metallische Oberfläche aufweisender Teile mit Hilfe eines Lotmaterials ergeben sich bei Anwendung der oben beschriebenen Behandlung völlig neue verfahrenstechnische Möglichkeiten. Bei einer besonders bevorzugten Verfahrensvariante werden die zu verbindenden Teile, beispielsweise ein DCB-Substrat und Si-Chips, unter Zwischenlage eines Lotmaterials in der vorgesehenen Lage zueinander positioniert und, ohne dass eine Vorreinigung der einzelnen Fügepartner mit herkömmlichen Methoden folgt, gemeinsam dem Niederdruckplasma ausgesetzt, wobei im Anschluss daran eine thermische Behandlung zum Erschmelzen des Lotmaterials erfolgt. Es hat sich überraschenderweise gezeigt, dass das Plasma seine Wirkung auch in den zwischen den Fügepartner vorhandenen Trennfugen entfaltet, und zwar auch dann, wenn als Lotmaterial eine Paste verwendet wird, die auf einer Oberfläche eines Fügepartners aufgebracht ist. Eine derartige Verfahrensweise lässt eine kontinuierliche Herstellung von Lötverbindungen, insbesondere von mit elektrischen und elektronischen Bauteilen bestückten Leiterplatten oder DCB-Substraten, zu.

Als besonders wirksam hat sich Tetrafluorkohlenstoff, also das vollständig fluorierte Methan, herausgestellt. Bei Verwendung dieser Fluorverbindung können die in Rede stehenden Oberflächen bei geringer Einwirkzeit des Niederdruckplasmas so vorbehandelt werden, dass bei einer späteren Verlötung ein Einsatz von Flussmitteln und Aktivatoren überhaupt nicht erforderlich ist.

Das Prozessgas umfasst neben dem fluorierten Kohlenwasserstoff noch ein weiteres Gas oder Gasgemisch, im Folgenden Restgas genannt. Vorzugsweise wird als Restgas reiner Stickstoff, Stickstoff mit einem Sauerstoffgehalt von 50 bis 10000 ppm oder Luft verwendet. Vorzugsweise wird ein Plasma mit einen Druck von 10 bis 100 Pa eingesetzt.

Die Erfindung wird nun unter Bezugnahme auf die beigefügten Zeichnungen näher erläutert. Es zeigen:
- Fig. 1: die Draufsicht auf eine ein Lötstellen-Array aufwei- sende DCB-Platte,
- Fig. 2: eine schematische Schnittdarstellung einer DCB- Platte, eines mit dieser elektrisch zu verbindenden Bauteils und zur Herstellung der Verbindung dienende Lötmaterial-Zuschnitte,
- Fig. 3: eine Anordnung entsprechend Fig. 2, wobei jedoch die Lötmaterial-Zuschnitte und das Bauteil auf der DCB- Platte aufliegen,
- Fig. 4: eine Anordnung entsprechend Fig. 3, wobei jedoch Löt- material in Pastenform vorhanden ist.

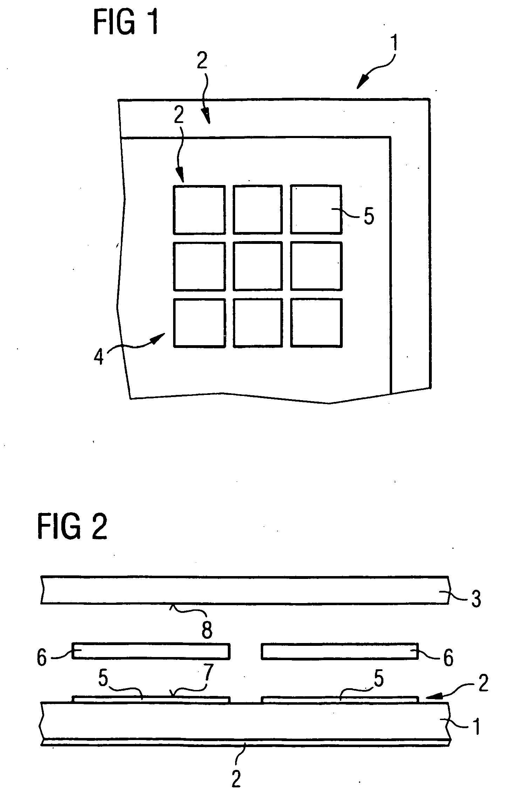

Fig. 1 zeigt als Beispiel eines mit elektrischen oder elektronischen Bauteilen 2 zu bestückenden Substrats eine Grundplatte 1. Die Grundplatte 1, beispielsweise ein DCB-Substrat aus einem elektrisch isolierenden und thermisch belastbaren Material wie Aluminiumoxid, ist ein oder beidseitig mit einer Kupferschicht 3 versehen. Auf der mit Bauteilen 2, etwa Thyristoren zu bestückenden Seite der Grundplatte 1 bildet die Kupferschicht ein Array 4 von 3x3 etwa quadratischen Lötstellen 5. Das Anlöten eines Bauteils 2 an einem Array 4 erfolgt im Falle von wärmeunempfindlichen Substraten beispielsweise so, dass auf der Grundplatte 1 bzw. auf den Lötstellenarrays 4 Bauteile 2 unter Zwischenlage von Lötmaterial positioniert werden und anschließend eine Wärmebehandlung erfolgt, bei der das Lötmaterial schmilzt. Die Behandlung der miteinander zu verlötenden Oberflächen 7, 8 der Bauteile 2 bzw. der Lötstellen 5 kann so erfolgen, dass sich ein Batchbetrieb oder eine kontinuierliche Betriebsweise ergibt. Im erstgenanten Fall werden die Fügepartner chargenweise in einem separaten Bearbeitungsschritt einem Niederdruckplasma ausgesetzt.

Das zu dessen Erzeugung verwendete Prozessgas ist eine Mischung aus einem gasförmigen Fluorkohlenwasserstoff, insbesondere Tetrafluormethan, und einem weiteren Gas oder Gasgemisch, das im folgenden als Restgas bezeichnet wird. Als Restgas ist reiner Stickstoff, einen Restsauerstoff von 50 ppm bis 10000 ppm aufweisender Stickstoff oder Luft vorhanden.

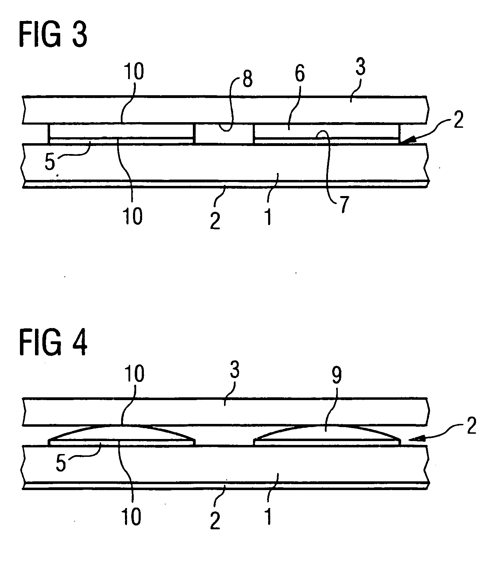

Die Moleküle des Fluorkohlenwasserstoffs und des Restgases werden durch Einkopplung eines hochfrequenten elektromagnetischen Feldes in hochangeregte Zustände überführt. In einer Plasmakammer mit einem Druck von etwa 10 Pa bis 100 Pa wirkt das Plasma auf die Oberflächen der sich in der Kammer befindlichen Fügepartner ein. Dabei reagieren die hochangeregten Gasmoleküle mit auf den Oberflächen vorhandenen Schmutzpartikeln und Oxidbelägen, wobei diese etwa durch radikalische Reaktionen umgewandelt und dabei von den Oberflächen entfernt werden. Es entstehen saubere und oxidfreie Oberflächen, die vollständig mit Lotmaterial benetzbar sind. Hinzu kommt ein weiterer Effekt, der eine chargenweise Verarbeitung erst ermöglicht, nämlich eine die Neuoxidation verhindernde Passivierung der Oberflächen. Die physikalisch-chemischen Grundlagen dieses Effekts sind noch ungeklärt. Wie durch Untersuchungen gezeigt werden konnte, beruht er nicht auf der Bildung einer die Oberflächen bedeckenden, den Zutritt von Luftsauerstoff verhindernden geschlossenen Beschichtung. Bei mit Tetrafluormethan durchgeführten Test wurde eine Passivierungsdauer von einigen Tagen erreicht. Innerhalb dieser Zeitspanne muss dann eine Verarbeitung der behandelten Fügepartner erfolgen, damit das Verlöten vorzugsweise ohne oder zumindest mit einem geringeren Einsatz von Flussmitteln und Aktivatoren erfolgen kann, so dass eine Entfernung von Flussmittel- und Aktivatorrückständen nicht oder nur in vermindertem Ausmaß erforderlich ist. Zur Durchführung des Lötverfahrens selbst werden Grundplatte 1 und Bauteile 2 in einer Anordnung etwa entsprechend Fig. 3 bzw. Fig. 4 zusammengestellt, wobei zwischen einem Bauteil 2 und den Lötstellen 5 Lötmaterial in Form von Zuschnitten 6 aus festem Lotmaterial oder in Form von Pastenportionen 9 vorhanden sind.

Bei einer kontinuierlichen Betriebsweise werden die Fügepartner beispielsweise entsprechen Fig. 3 oder 4 zusammengestellt und einer Behandlung mit einem Niederdruckplasma der oben beschriebenen Art in einer Plasmakammer unterzogen. Bei einer derartigen Vorgehensweise war überraschend, dass das Niederdruckplasma in die Trennfugen 10 zwischen Lötmaterial und Bauteil 3 bzw. Lötstelle 4 eindringt und dort seine Wirkung entfaltet, obwohl diese, insbesondere im Fall der Verwendung von Pastenportionen, nur ein äußerst geringes Ausmaß aufweisen.

## Patentansprüche

1. Lötverfahren zur elektrisch leitenden Verbindung zweier eine metallische Oberfläche aufweisender Teile mit Hilfe eines Lotmaterials, bei dem die miteinander zu verbindenden Teile unter Zwischenlage eines Lotmaterials in der vorgesehenen Lage zueinander positioniert und gemeinsam in einer Plasmakammer mit einem Niederdruckplasma vorbehandelt werden, zu dessen Erzeugung ein Prozessgas verwendet wird, das sich aus einem fluorierten Kohlenwasserstoff und einem Restgas zusammensetzt, wobei im Anschluss an die Vorbehandlung eine thermische Behandlung zum Erschmelzen des Lotmaterials erfolgt.

2. Verfahren nach Anspruch 1, bei dem die zu verbindenden Teile eine Grundplatte (1) und elektrische oder elektronische Bauteile (3) sind.

3. Verfahren nach Anspruch 1 oder 2, bei dem das Plasma Tetrafluorkohlenstoff enthält.

4. Verfahren nach einem der vorhergehenden Ansprüche, bei dem das Restgas reiner Stickstoff ist.

5. Verfahren nach einem der Ansprüche 1 bis 3, bei dem das Restgas Stickstoff mit einem Sauerstoffgehalt von 50 bis 10000 ppm verwendet wird.

6. Verfahren nach einem der Ansprüche 1 bis 3, bei dem das Restgas Luft ist.

7. Verfahren nach einem der vorhergehenden Ansprüche, bei dem das Plasma einen Druck von 10 bis 100 Pa aufweist.

8. Verfahren nach einem der vorhergehenden Ansprüche, bei dem als Lotmaterial eine Paste verwendet wird.

9. Verfahren nach einem der vorhergehenden Ansprüche, bei dem als Lotmaterial Zuschnitte aus einem festen Lotmaterial verwendet werden.

## Claims

1. Solder method for the electrically conducting connection of two parts comprising a metallic surface with the aid of a solder material, in which the parts to be connected to one another are positioned relative to one another by interlaying a solder material in the position provided and are pretreated in a shared manner in a plasma chamber with a low-pressure plasma, a process gas being used for the generation thereof, which is composed of a fluorinated hydrocarbon and a residual gas, with a thermal treatment for smelting the solder material taking place subsequent to the pretreatment.

2. Method according to claim 1, in which the parts to be connected are a base plate (1) and electrical or electronic components (3).

3. Method according to claim 1 or 2, in which the plasma contains tetrafluorocarbon.

4. Method according to one of the preceding claims, in which the residual gas is pure nitrogen.

5. Method according to one of claims 1 to 3, in which the residual gas is nitrogen with an oxygen content of 50 to 10000 ppm.

6. Method according to one of claims 1 to 3, in which the residual gas is air.

7. Method according to one of the preceding claims, in which the plasma has a pressure of 10 to 100 Pa.

8. Method according to one of the preceding claims, in which a paste is used as solder material.

9. Method according to one of the preceding claims, in which cuts from a solid solder material are used as solder material.

## Revendications

1. Procédé de soudage à l'aide d'un matériau de soudage pour la jonction électroconductrice de deux pièces présentant une surface métallique, dans lequel les pièces à raccorder entre elles sont positionnées l'une par rapport à l'autre dans la position prévue avec pose intercalaire d'un matériau de soudage et sont prétraitées en commun dans une chambre à plasma avec un plasma à basse pression, pour la production duquel on utilise un gaz de processus qui se compose d'un hydrocarbure fluoré et d'un gaz résiduaire, un traitement thermique destiné à faire fondre le matériau de soudage ayant lieu après le prétraitement.

2. Procédé selon la revendication 1, dans lequel les pièces à raccorder sont une plaque de base (1) et des composants électriques ou électroniques (3).

3. Procédé selon la revendication 1 ou 2, dans lequel le plasma contient du tétrachlorure de carbone.

4. Procédé selon l'une quelconque des revendications précédentes, dans lequel le gaz résiduaire est de l'azote pur.

5. Procédé selon l'une quelconque des revendications 1 à 3, dans lequel de l'azote ayant une conteneur en oxygène de 50 à 10000 ppm est utilisé comme gaz résiduaire.

6. Procédé selon l'une quelconque des revendications 1 à 3, dans lequel le gaz résiduaire est de l'air.

7. Procédé selon l'une quelconque des revendications précédentes, dans lequel le plasma présente une pression de 10 à 100 Pa.

8. Procédé selon l'une quelconque des revendications précédentes, dans lequel une pâte est utilisée comme matériau de soudage.

9. Procédé selon l'une quelconque des revendications précédentes, dans lequel des pièces découpées d'un matériau de soudage solide sont utilisées comme matériau de soudage.
